# DEMANDE DE BREVET EUROPEEN

(11) **EP 1 720 198 A2**
(43) Date de publication de la demande: **08.11.2006**
(21) Numéro de dépôt: 06290681.3
(22) Date de dépôt: 27.04.2006
(51) Int. Cl.: H01L 21/02, H01L 21/334

(54) **Circuit intégré comprenant au moins un condensateur et procédé de formation du condensateur**

(30) Priorité: 04.05.2005 FR 0504536
(71) Demandeur: STMicroelectronics SA, 92120 Montrouge (FR); STMicroelectronics ( Crolles 2) SAS, 38920 Crolles (FR)
(72) Inventeur: Giraudin, Jean-Christophe, 38190 Bernin (FR); Fiori, Vincent, 38360 Sassenage (FR); Delpech, Philippe, 38240 Meylan (FR)
(74) Mandataire: Zapalowicz, Francis

(57) **Abrégé**

Circuit intégré comprenant au moins un condensateur 6 formé sur une couche 1 munie d'au moins une tranchée 2, ledit condensateur 6, muni d'une couche diélectrique 4 séparant deux électrodes 3,5, épousant la forme de la tranchée 2, le condensateur 6 laissant subsister une partie 2d de la tranchée 2 et en ce qu'un matériau 7,8 susceptible d'absorber les contraintes liées aux déplacements des parois de la tranchée est disposé dans ladite partie 2d de la tranchée 2.

## Description

La présente invention est relative à la formation de condensateurs au sein d'un circuit intégré.

Dans les circuits intégrés, et notamment les circuits intégrés de type radio-fréquence, les condensateurs occupent une très grande place, d'où un coût élevé. Ainsi, on recherche à augmenter la capacité de ces condensateurs par unité de surface, tout en conservant les performances exigées par les applications radio-fréquence.

Pour cela, il est connu de former des condensateurs en trois dimensions dans des tranchées ou des puits, ce qui permet d'augmenter la densité surfacique des électrodes.

On constate toutefois qu'avec ce procédé les contraintes mécaniques des matériaux utilisés pour former les condensateurs engendrent des décollements importants, notamment des parois des tranchées. Ces contraintes, qui s'exercent sur la couche de diélectrique des condensateurs, peuvent entraîner une dégradation des performances électriques du circuit. Elles peuvent ainsi provoquer un claquage prématuré des condensateurs ou une augmentation des courants de fuite.

La demanderesse a observé de manière surprenante que l'on pouvait remédier à ces inconvénients en formant le condensateur dans la tranchée de façon à laisser subsister une partie de la tranchée et en disposant - dans cette partie de la tranchée un matériau susceptible d'absorber les contraintes liées aux déplacements des parois de la tranchée.

Elle a constaté que cette structure particulière du circuit permettait d'éviter dans une large mesure le décollement des condensateurs dans le circuit intégré et permettait de conserver de bonnes performances électriques du circuit.

L'invention propose donc un circuit intégré comprenant au moins un condensateur formé sur une couche munie d'au moins une tranchée, ledit condensateur, muni d'une couche diélectrique séparant deux électrodes, épousant la forme de la tranchée. En outre, le condensateur laisse subsister une partie de la tranchée et un matériau susceptible d'absorber les contraintes liées aux déplacements des parois de la tranchée est disposé dans ladite partie de la tranchée.

En d'autres termes, d'une façon générale, on dispose dans les tranchées un matériau qui a pour fonction d'amortir les mouvements des parois des différentes tranchées du circuit intégré. Le matériau utilisé permet de mieux répartir l'intensité des forces qui s'exercent horizontalement le long du circuit. Le matériau est notamment susceptible de se déformer, et notamment de se comprimer, afin d'absorber les contraintes, et notamment les contraintes de cisaillement.

L'invention propose également un procédé de formation d'au moins un condensateur sur une couche munie d'au moins une tranchée, ledit condensateur, muni d'une couche diélectrique séparant deux électrodes, épousant la forme de la tranchée. Selon le procédé, le condensateur est formé de façon à laisser subsister une partie de la tranchée et on dispose dans ladite partie de la tranchée un matériau susceptible d'absorber les contraintes liées aux déplacements des parois de la tranchée.

Selon un mode de réalisation, ledit matériau est un matériau de module d'Young inférieur à 100 GPa (i.e. inférieur à 10¹¹ Pa). Ce choix du module d'Young permet une bonne absorption des contraintes.

Ce matériau peut notamment être l'oxyde de silicium (SiO₂). Ce matériau peut être utilisé dans d'autres zones du circuit intégré, ce qui présente un avantage économique.

Selon un autre mode de réalisation, ledit matériau présente une partie intérieure vide. Dans ce cas, ledit matériau peut être choisi matériaux couramment utilisés dans l'industrie microélectronique tels que le SiO₂, les métaux ou composés métalliques TiN, TaN, W ou tout autre matériau isolant ou conducteur. Il peut notamment être choisi parmi les matériaux de module d'Young inférieur à 100 GPa. La partie intérieure vide du matériau permet une meilleure absorption des contraintes.

Selon un mode de réalisation, la partie intérieure vide est située à distance des électrodes du condensateur. De cette façon, les contraintes sont absorbées de façon homogène le long de la hauteur de la tranchée.

Le condensateur peut être formé par dépôt successif d'une première électrode, d'une couche diélectrique et d'une deuxième électrode, les couches successives étant déposées de façon à épouser la forme de la tranchée. La tranchée est notamment de section rectangulaire.

Le matériau susceptible d'absorber les contraintes liées aux déplacements des parois de la tranchée peut être déposé par toute technique de dépôt en phase vapeur, et notamment par dépôt chimique en phase vapeur assisté par plasma (PECVD en langue anglaise : Plasma Enhanced Chemical Vapor Deposition) ou par centrifugation.

Dans le cas où le matériau présente une partie intérieure vide, la formation de la partie intérieure vide peut être obtenue par un procédé de dépôt permettant la formation de vide, comme par exemple par dépôt chimique en phase vapeur. Les conditions peuvent ainsi être choisies de manière à favoriser la formation d'un surplus de matière dans les extrémités inférieures et supérieures de la tranchée ou de manière à favoriser l'appauvrissement de matière à l'intérieur de la tranchée. Pour un dépôt de W par CVD, on peut ainsi choisir une température de dépôt comprise entre 410 et 430°C.

Selon un autre mode de réalisation, la couche sur laquelle est formée le condensateur comprend une tranchée supplémentaire qui contient un matériau susceptible d'absorber les contraintes liées aux déplacements des parois de la tranchée, ladite tranchée supplémentaire entourant au moins une partie de l'ensemble formée par les tranchées décrites ci-dessus. La présence de cette tranchée supplémentaire permet une meilleure absorption des contraintes.

Les tranchées peuvent contenir un matériau de module d'Young inférieur à 100 Gpa et la tranchée supplémentaire peut contenir un matériau présentant une partie intérieure vide. On peut également envisager que les tranchées contiennent un matériau présentant une partie intérieure vide et que la tranchée supplémentaire contienne un matériau de module d'Young inférieur à 100 Gpa.

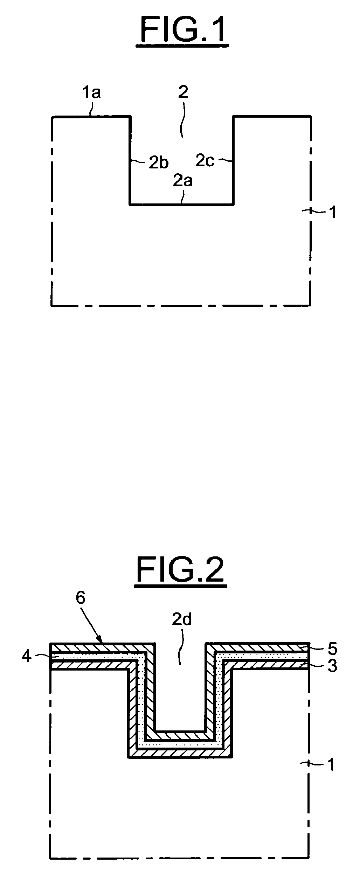

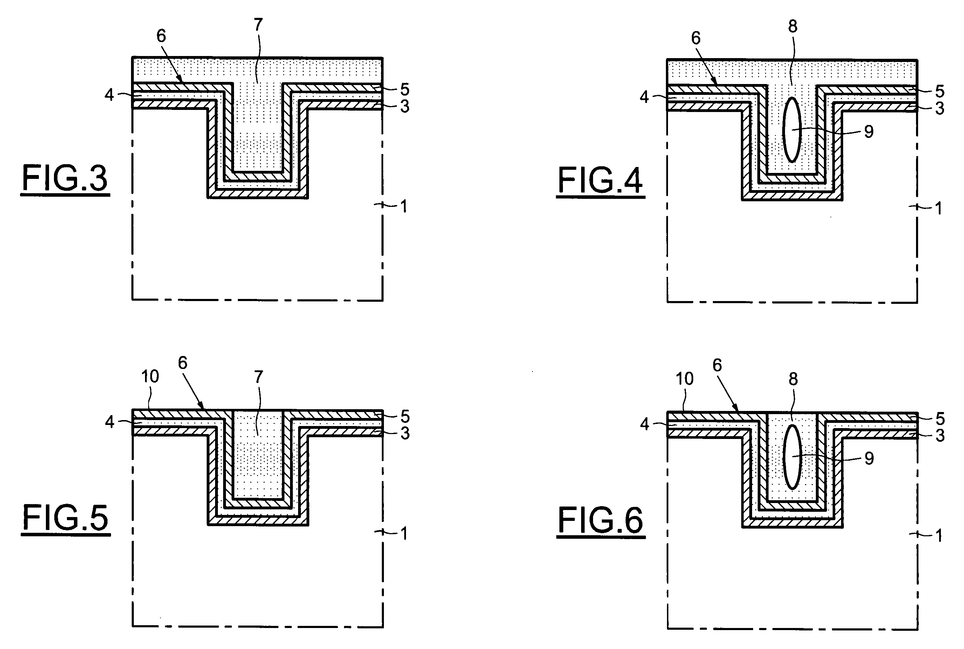

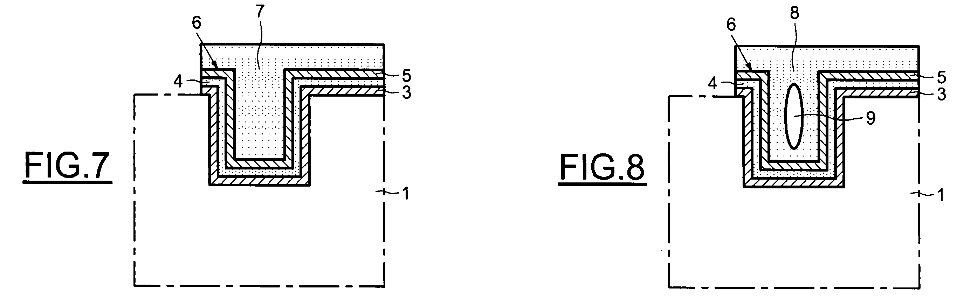

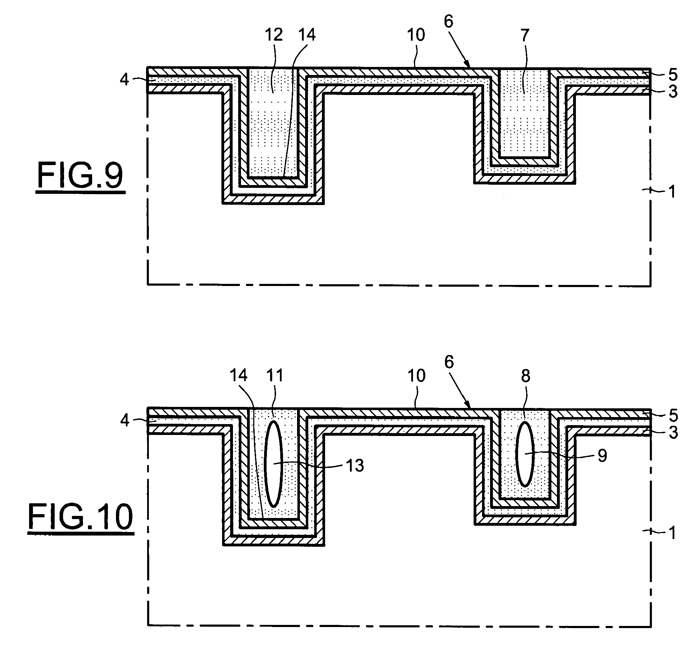

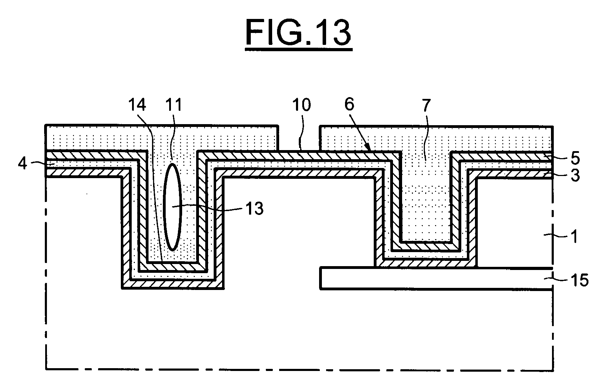

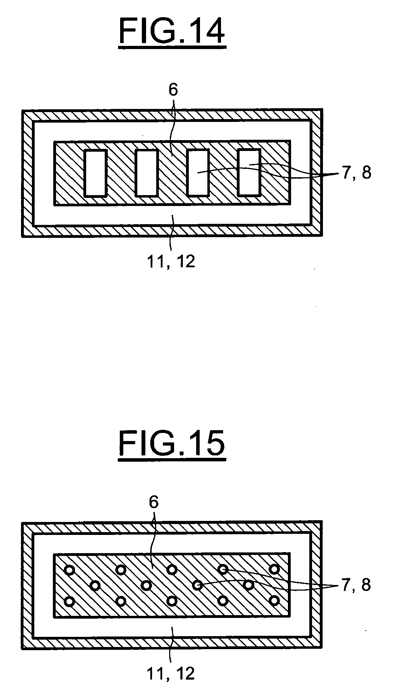

D'autres avantages et caractéristiques de l'invention apparaîtront à l'examen de la description détaillée de modes de mise en oeuvre et de réalisation' nullement limitatifs, et des dessins annexés sur lesquels les figures 1 à 15 illustrent schématiquement les étapes principales de deux modes de mise en oeuvre du procédé de l'invention aboutissant à deux modes de réalisation d'un circuit intégré selon l'invention. Les figures 1 à 3 et 5 illustrent un premier mode de réalisation et les figures 4 et 6 un deuxième mode de réalisation correspondant à une variante des étapes illustrées aux figures 3 et 5. Les figures 7 et 8 illustrent une première variante de ces deux modes de réalisation. Les figures 9 à 15 illustrent une deuxième variante de ces deux modes de réalisation.

Les figures 1 à 13 sont des coupes transversales du circuit intégré à différentes étapes du procédé de formation du condensateur selon l'invention.

La figure 1 montre une couche 1, pouvant être en silicium, verre, SiO₂ ou tout autre matériau isolant. La couche 1 est typiquement un substrat, de surface supérieure plane 1a. On grave une tranchée rectangulaire 2 dans la couche 1, par exemple par gravure sèche au fluor. La tranchée 2 présente un fond 2a parallèle à la surface supérieure plane la de la couche 1, ainsi que des bords parallèles 2b et 2c, de longueur généralement supérieure à celle du fond 2a. La profondeur de la tranchée 2 est généralement comprise entre 1 et 200 µm. On pourra par exemple former des tranchées de profondeur comprise entre 1 et 10 µm dans une zone d'interconnexions ou de profondeur comprise entre 10 et 100 µm dans un substrat.

On forme ensuite un condensateur 6 (figure 2) en déposant successivement une première électrode sous la forme d'une couche 3, une couche de diélectrique 4 et une deuxième électrode sous la forme d'une deuxième couche 5. Les trois couches 3,4,5 constituant le condensateur 6 sont déposées de façon à épouser la forme de la tranchée 2. Ainsi, les couches 3,4,5 présentent chacune deux portions parallèles à la surface supérieure plane la de la couche 1 , de chaque côté de la tranchée 2, une portion parallèle au bord 2b, une portion parallèle au fond 2a et une portion parallèle au deuxième bord 2c de la tranchée 2. De cette façon, les couches 3,4,5 sont sensiblement parallèles entre elles.

Les électrodes sont typiquement à base de TiN, TaN ou encore W. Le diélectrique peut être choisi parmi Al₂O₃, Ta₂O₅, HfO₂, SiO₂ et SiN, ou tout autre matériau diélectrique, ainsi que parmi les combinaisons de ces matériaux. Le dépôt des différentes couches 3,4,5 peut être effectué par toute technique connue de l'homme du métier. Le dépôt des électrodes peut notamment être réalisé par dépôt par couches atomiques (ALD en langue anglaise : Atomic Layer Deposition) ou par dépôt chimique en phase vapeur (CVD en langue anglaise : Chemical Vapor Deposition).

Comme les couches 3,4,5 constituant le condensateur 6 sont déposées en épousant les formes des bords 2b,2c et du fond 2a de la tranchée 2, il subsiste naturellement une partie 2d de la tranchée 2. De cette façon, il est possible de disposer dans ladite partie 2d de la tranchée 2 un matériau susceptible d'absorber les contraintes liées aux déplacements des parois de la tranchée 2.

Selon un premier mode de réalisation (figure 3), le matériau susceptible d'absorber les contraintes liées aux déplacements des parois de la tranchée 2 est un matériau 7 de module d'Young inférieur à 100 GPa, et notamment compris entre 50 et 90 GPa. Le matériau 7 est typiquement de l'oxyde de silicium déposé à partir de tétraéthylorthosilicate (TEOS), qui présente un module d'Young de l'ordre de 60 GPa, du SiOC, un polymère, notamment un polyimide. Le matériau 7 est de préférence déposé par CVD, mais on peut également envisager un dépôt par centrifugation. Le matériau 7 remplit entièrement la partie 2d de la tranchée 2.

Selon un deuxième mode de réalisation (figure 4), le matériau susceptible d'absorber les contraintes liées aux déplacements des parois de la tranchée 2 est un matériau 8 qui présente une partie intérieure vide 9. Le matériau 8 est déposé par un procédé permettant la formation de la partie vide 9, notamment par dépôt chimique en phase vapeur. Le matériau 8 peut être choisi parmi les matériaux susceptibles d'être déposés par CVD. On utilise typiquement du tungstène. Le matériau 8 peut également être choisi parmi les SiOC, les polymères, notamment les polyimides.

La partie vide 9 est située, de préférence, à distance des électrodes 3,5. Pour ce faire, on ajuste les paramètres de flux de gaz et de pression du gaz lors du dépôt chimique en phase vapeur afin de déposer simultanément le matériau 8 dans les coins inférieurs et supérieurs de la tranchée 2d. De cette façon, l'extrémité supérieure de la tranchée 2d est obturée avant que le coeur de la tranchée 2d ne soit rempli de matériau 8.

Après le dépôt du matériau 7,8, il subsiste du matériau 7,8 sur la surface supérieure 10 du condensateur constituée des portions de l'électrode 5 parallèles à la surface supérieure 1a de la couche 1.

On procède à un polissage mécano-chimique du matériau 7,8, afin d'enlever le matériau 7,8 de la surface externe 10 du condensateur 6. La partie vide 9 du matériau 8 est formée sous la surface supérieure du matériau 8. Grâce au polissage mécano-chimique, le matériau 7,8 ne subsiste que dans la tranchée 2d et la surface supérieure du matériau 7,8 est alignée avec la surface supérieure 10 du condensateur 6, ce qui permet de faciliter la formation ultérieure de connexions. Les figures 5 et 6 illustrent le circuit intégré selon les deux modes de réalisation décrits plus haut, à l'issue de l'étape de polissage mécano-chimique.

En d'autres termes, la partie subsistante 2d de la tranchée 2 est occupée par un élément de remplissage relativement souple et pouvant être isolant ou conducteur.

Selon une variante de ces deux modes de réalisation, illustrée sur les figures 7 et 8, l'extrémité du condensateur 6 est gravée par photolithogravure.

Grâce à sa capacité à absorber les contraintes, le matériau 7,8 utilisé dans le procédé de l'invention peut se comprimer latéralement sous l'action de contraintes ce qui permet de stabiliser mécaniquement le circuit intégré et d'éviter la transmission de contraintes à des structures voisines qui risquent alors une détérioration. On constate en particulier que lorsque le matériau 8 présente une partie intérieure vide 9, la contrainte normale moyenne en pied de tranchée est sensiblement diminuée par rapport à un matériau 7 en tungstène ne présentant pas de partie intérieure vide 9 (réduction de l'ordre de 40% lorsque la couche 1 est en silicium et de l'ordre de 60% lorsque la couche 1 est en oxyde de silicium).

La réduction des contraintes peut encore être amplifiée en mettant en oeuvre le circuit tel qu'illustré sur les figures 9 et 10. Une tranchée supplémentaire 14 est disposée autour de l'ensemble formé par les tranchées 2 remplies de matériau 7,8. La tranchée supplémentaire 14 est formée de la même manière que les tranchées 2. Comme les tranchées 2, elle contient un matériau 11,12 susceptible d'absorber les contraintes liées aux déplacements des parois de la tranchée. Elle peut être de même profondeur que les tranchées 2 si on a utilisé une couche d'arrêt de gravure pour former les tranchées 2. Dans ce cas, la tranchée supplémentaire 14 peut être formée en utilisant la même couche d'arrêt de gravure. Toutefois, la tranchée supplémentaire 14 est de préférence plus profonde que les tranchées 2, pour réduire encore les contraintes mécaniques. A cet effet, la tranchée supplémentaire 14 est également de préférence plus large. Il est à noter que ce mode de réalisation ne nécessite aucune étape supplémentaire. Le matériau 11,12 susceptible d'absorber les contraintes liées aux déplacements des parois de la tranchée supplémentaire peut indifféremment être choisi parmi les matériaux 12 de module d'Young inférieur à 100 GPa et les matériaux 11 présentant une partie intérieure vide 13 décrits ci-dessus, indépendamment du matériau présent dans les tranchées 2.

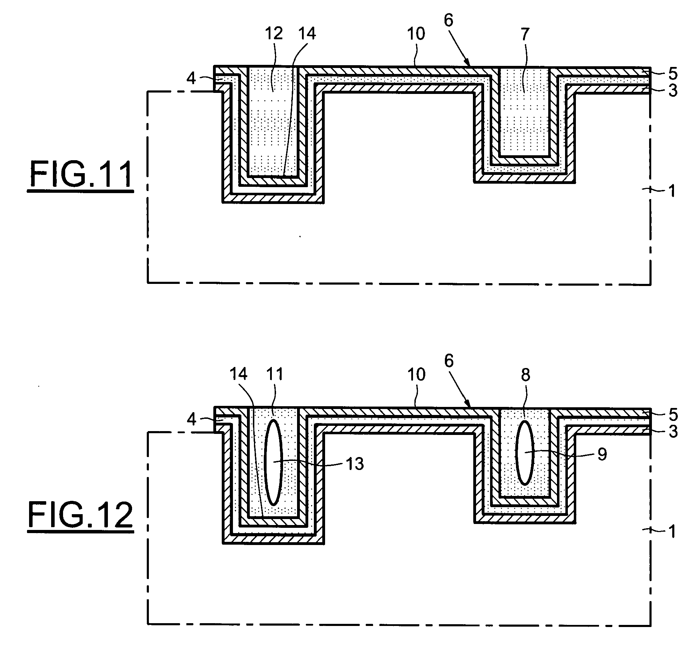

Selon une variante illustrée sur les figures 11 et 12, l'extrémité du condensateur 6 est gravée par photolithogravure.

La figure 13 illustre le cas où l'on a utilisé une couche d'arrêt de gravure 15 pour former la tranchée 2. Le matériau 11 présent dans la tranchée supplémentaire 14 présente une partie intérieure vide 13.

La figure 14 illustre le circuit, et notamment le condensateur 6, vu de dessus. Le matériau 11,12 présent dans 1 a tranchée supplémentaire 14 entoure l'ensemble formé par les matériaux 7,8 présents dans les tranchées 2.

La figure 15 illustre une variante, dans laquelle le condensateur 6 est formé dans des puits. Les puits peuvent être de toute forme, notamment circulaire. De préférence, les puits sont disposés de telle sorte que chaque puit est équidistant des puits voisins. Une telle disposition permet une bonne rigidité mécanique pour une surface et un nombre de puits optimaux.

Lorsque que la tranchée supplémentaire 14 est présente, avec un matériau 11 susceptible d'absorber les contraintes présentant une partie intérieure 13 vide, on constate que la contrainte normale moyenne en pied de tranchée est encore davantage diminuée par rapport à un matériau 7 en tungstène ne présentant pas de partie intérieure vide 9 (réduction de l'ordre de 98% lorsque la couche 1 est en silicium et de l'ordre de 94% lorsque la couche 1 est en oxyde de silicium).

## Revendications

1. Circuit intégré comprenant au moins un condensateur (6) formé sur une couche (1) munie d' au moins une tranchée (2), ledit condensateur (6), muni d'une couche diélectrique (4) séparant deux électrodes (3,5), épousant la forme de la tranchée (2), **caractérisé en ce que** le condensateur (6) laisse subsister une partie (2d) de la tranchée (2) et **en ce qu'**un matériau (7,8) susceptible d'absorber les contraintes liées aux déplacements des parois de la tranchée (2) est disposé dans ladite partie (2d) de la tranchée (2).

2. Circuit intégré selon la revendication 1, **caractérisé en ce que** ledit matériau (7) est un matériau de module d'Young inférieur à 100 GPa.

3. Circuit intégré selon la revendication 1, **caractérisé en ce que** ledit matériau (7) est choisi parmi SiO₂, SiOC, les polymères.

4. Circuit intégré selon la revendication 1, **caractérisé en ce que** ledit matériau (8) présente une partie intérieure vide (9).

5. Circuit intégré selon la revendication 4, **caractérisé en ce que** la partie intérieure vide (9) est située à distance des électrodes (3,5) du condensateur (6).

6. Circuit intégré selon la revendication 4 ou 5, **caractérisé en ce que** ledit matériau (8) est choisi parmi le tungstène, le tétraéthylorthosilicate ou un composé comprenant du tétraéthylorthosilicate, du SiOC, ou des polymères.

7. Circuit intégré selon l'une des revendications 1 à 6, **caractérisé en ce que** la couche (1) comprend une tranchée supplémentaire (14) contenant un matériau (11,12) susceptible d'absorber les contraintes liées aux déplacements des parois de la tranchée (14), ladite tranchée supplémentaire entourant au moins une partie de l'ensemble formé par les tranchées (2).

8. Circuit intégré selon la revendication 7, **caractérisé en ce que** les tranchées (2) contiennent un matériau (7) de module d'Young inférieur à 100 Gpa et **en ce que** la tranchée supplémentaire (14) contient un matériau (11) présentant une partie intérieure vide (13).

9. Circuit intégré selon la revendication 7, **caractérisé en ce que** les tranchées (2) contiennent un matériau (8) présentant une partie intérieure vide (9) et **en ce que** la tranchée supplémentaire (14) contient un matériau (12) de module d'Young inférieur à 100 Gpa.

10. Procédé de formation d'au moins un condensateur (6) sur une couche (1) munie d'au moins une tranchée (2), ledit condensateur (6), muni d'une couche diélectrique (4) séparant deux électrodes (3,5), épousant la forme de la tranchée (2), **caractérisé en ce** le condensateur (6) est formé de façon à laisser subsister une partie (2d) de la tranchée (2) et en ce qu'on dispose dans ladite partie (2d) de la tranchée (2) un matériau (7,8) susceptible d'absorber les contraintes liées aux déplacements des parois de la tranchée (2).

11. Procédé selon la revendication 10, **caractérisé en ce que** ledit matériau (8) est obtenu par formation d'une partie intérieure vide (9) dans un matériau (8).

12. Procédé selon la revendication 11, **caractérisé en ce que** la partie intérieure vide (9) est située à distance des électrodes (3,5) du condensateur (6).

13. Procédé selon la revendication 11 ou 12, **caractérisé en ce que** la formation de la partie intérieure vide (9) est obtenue par dépôt chimique en phase vapeur.
